Europäisches Patentamt

European Patent Office

Office européen des brevets

(19)

(11)  **EP 1 466 408 B1**

(12)  **EUROPEAN PATENT SPECIFICATION**

(45) Date of publication and mention
of the grant of the patent:
**05.07.2006  Bulletin 2006/27**

(51) Int Cl.:
**H03F 1/32** (2006.01)

(21) Application number: **03729431.1**

(86) International application number:
**PCT/EP2003/000101**

(22) Date of filing: **08.01.2003**

(87) International publication number:
**WO 2003/061116 (24.07.2003 Gazette 2003/30)**

(54) **IMPROVEMENTS IN OR RELATING TO POWER AMPLIFIERS**

VERBESSERUNG AN ODER BEZÜGLICH LEISTUNGSVERSTÄRKERN

AMELIORATIONS RELATIVES A DES AMPLIFICATEURS DE PUISSANCE

(84) Designated Contracting States:
**DE FR GB**

(30) Priority: **18.01.2002  GB 0201134**
**22.04.2002  GB 0209106**

(43) Date of publication of application:
**13.10.2004  Bulletin 2004/42**

(73) Proprietor: **SIEMENS AKTIENGESELLSCHAFT**
**80333 München (DE)**

(72) Inventor: **DOMOKOS, John**
**Salisbury, Wiltshire SP1 1NH (GB)**

(74) Representative: **Payne, Janice Julia**
**Siemens Corporate Shared Services**
**Siemens AG**
**P.O. Box 22 16 34**
**80506 München (DE)**

(56) References cited:
**WO-A-00/48308          DE-A- 10 009 596**
**US-A- 4 462 001**

## Description

The present invention relates to improvements in or relating to power amplifiers. In particular, the invention relates to improving the efficiency of power amplifiers, in the base station apparatus of radio telecommunications systems.

In radio telecommunications systems, high power base stations are used to establish connections to a plurality of mobile units (handsets). The new 2.5G and 3rd generation (3G) telecommunications systems, such as GPRS and UMTS, demand certain features in the base stations. Notably 2.5G and 3G systems require the base stations to use high power amplifiers.

Power amplifiers (PA) are used in both base stations and mobile handsets to amplify input signals. In much of the following discussions the examples of input signals are simple two-tone signals having tones at two distinct frequencies, $f_1$ and $f_2$. Input signals amplified by PAs are more generally multicarrier signals.

The PAs used in base stations must be robust at high power levels. Substantially linear transfer characteristics are considered important to the provision of robust high power amplifiers (HPA).

An ideal linear amplifier would give an amplified version of an input signal, which at every point in its operating range has been amplified by a constant factor.

One result of the use of non-ideal power amplifiers can be the appearance of intolerable levels of side band distortion.

Distortion in PAs may be both amplitude distortion and phase distortion. An amplifier may cause an amplitude modulation to phase modulation (AM/PM) transfer characteristic, whereby phase variations in the output amplified signal are dependent upon amplitude variations in the input signal. Distortion may also be purely or partly AM/AM in nature.

Distortion is a consequence of physical factors, including changes in the operational characteristics of the PA, temperature variations, power supply fluctuations and load mis-matches.

In the absence of PAs with perfect linear transfer characteristics, some non-linear distortion effects are to be expected. Distortion effects can appear as specious signals having frequencies which are generally in simple arithmetic selection as input frequencies; for example harmonic distortion and intermodulation distortions (IMD).

Intermodulation and harmonic distortions are important classes of effects generally termed "mixing products".

For the purposes of the following discussion, intermodulation distortion (IMD) products can be characterised in terms of their origins. The "order" of a mixing product, f, is given by the sum:

$$O(f) = |m| + |n| + \ \ldots\ldots + \ |z|$$

where

$$f = mf_1 + nf_2 + \ldots\ldots + zf_i$$

Thus the third harmonic of $f_1$, $3f_1$, is of order three; so too is the IMD product $(2f_1 - f_2)$. A short hand for 3rd order intermodulation distortion product, IM3, will be adopted hereafter.

In the high power amplified generally used in broadband radio frequency (RF) communications systems, the present of IMD is highly unwelcome. Amplification of the multicarrier signals of 2.5G and 3G systems leads to a plethora of IMD products as each channel can potentially mix with every other channel.

In response to non-linear transfer characteristics in PAs, it is known to seek to compensate for non-linearities. The apparatus for compensating for non-linear transfer characteristics is variously termed 'predistorter', 'linearizer' and 'equaliser'. The difference between terms is one of emphasis: a predistorter being an apparatus for applying a predistortion that seeks to complement any distortion introduced by the component of a PA. 'linearizer' emphasis the need to bring the combine linearizer and PA arrangement as close as possible to an ideal linear PA.

All compensating apparatus share the feature that they seek to apply a compensating function to counter the distorting effects of PAs. The compensating function may be viewed as an approximation to the inverse or complimentary function to the non-linear transfer function associated with the PA.

The inverse function can be modelled in a variety of ways. In one example an arrangement of diodes is provided, the arrangement approximating the inverse of the distortion effects in the PA. In further examples software is used to emulate the effect of hardware predistortion devices in real time.

Both the non-linear transfer function and the complementary predistortion function may be approximated by polynomial expansions. Polynomial predistortion is known.

It is further remarked that compensating apparatus is generally implemented within either a feed-forward or a feed-back circuit arrangement.

Adaptive predistortion has been shown to be an essential technique for reducing the peak error power, and hence improving the efficiency of feed-forward amplifiers. Known polynomial predistorters, such as the predistorter disclosed in UK patent application number GB 0123494.7 (attorney docket number 2001P09343), are unfortunately not effective for frequency dependent non-linear distortion where memory is required.

In the following discussion, the term memory refers to the dispersion of a signal through components which results in the delay of the signal.

When a PA displays memory effects, at least a component of the non-linear transfer characteristics will depend significantly upon previous signals passing through the PA. Consequently, the predistorter used to compensate for the memory effects must have memory too.

Furthermore, from recent research it has been realised that the dependency of IM3 products on both carrier frequency and envelope frequency can be significant. The dependency of the IM3 products upon envelope frequency is generally stronger.

In the case of envelope frequency dependency, the strength of the response can be damped. A compensating apparatus must therefore be provided with means to compensate for envelope frequency dependence and potentially memory effects too.

It is therefore an object of the invention to obviate or at least mitigate the aforementioned problems.

In accordance with one aspect of the present invention, there is provided a compensating apparatus for compensating for intermodulation products, the apparatus comprising: a phase splitting unit, which splits an input RF signal into an in-phase component and a quadrature component; first multiplying units, which square the value of the in-phase component and the quadrature component respectively and sum the squared values to generate an $X^2$ signal; combining units, which combine the $X^2$ signal, the in-phase and quadrature components, and an external signal with respective predistorting coefficients; and an adder, which generates a predistorted RF signal from the output of the combining units.

The compensating apparatus may be provided upon an application specific integrated circuit.

An output carrying the $X^2$ signal may be coupled to a delay unit (T1) and the output of the delay unit is fed back into the apparatus as the external signal, so that the external signal is a delayed signal derived from the $X^2$ signal.

Alternatively the apparatus may further comprise a further multiplier, which squares the $X^2$ signal again to give a $X^4$ signal, wherein the external signal is the $X^4$ signal.

By cascading more than one instance of the compensating apparatus, both carrier frequency and envelope frequency dependent effects due to IM3 products may be compensated for substantially simultaneously.

In a further aspect of the present invention there is provided a hybrid compensating apparatus for substantially simultaneously compensating for both carrier frequency and envelope frequency dependent effects due to IM3 products, the hybrid apparatus comprising: a first compensating apparatus coupled to a delay unit and arranged to compensate for envelope frequency effects; a second compensating apparatus, arranged to compensate for carrier frequency effects; a carrier delay unit, which imposes a predetermined delay upon the RF input signal supplied to the second compensating apparatus; and a further adder which sums the outputs of the first and second compensating apparatuses.

In accordance with another aspect of the present invention there is provided a feed forward amplifier arrangement comprising: a compensating apparatus as above; an amplifier having non-linear transfer characteristics that distort signals amplified thereby, the amplifier being coupled to the output of the compensating apparatus; a controller which generates coefficients for feeding into the compensating apparatus; and a sampling means which samples an output signal from the amplifier and which feeds the sample back to the controller.

In accordance with a further aspect of the present invention, there is provided a method of compensating for intermodulation products, the method comprising: splitting an input RF signal into an in-phase component and a quadrature component; squaring the in-phase component and the quadrature component respectively and summing their squares to generate an $X^2$ signal; combining the $X^2$ signal, the in-phase and quadrature components, and an external signal with respective predistorting coefficients; and generating a predistorted RF signal.

The compensating apparatus may also be referred to hereafter as an adaptive polynomial equaliser (APE). As will be understood, the APE is a modified polynomial predistorter and is able to compensate for envelope and carrier frequency dependent effects even when the transfer characteristics of the PA include memory effects.

The following discussion also delineates an architecture for a radio frequency application specific integrated circuit (RF-ASIC) predistorter. The proposed APE implements a predistortion technique that is re-configurable for narrowband and broadband applications. As such, the proposed APE improves efficiency and bandwidth of feed forward amplifiers.

Further benefit of the APE is to reduce substantially the error amplifier size to an extent that the costly output filter delay is minimised.

For a better understanding of the present invention, reference will now be made, by way of example only, to the accompanying drawings in which:-

Figure 1 shows IM3 products as measured on a first PA device, Device A;

Figure 2 shows IM3 products as measured on a second PA device, Device B;

Figure 3 shows a model for PA linear transfer function;

Figure 4 shows a model for carrier frequency dependent non-linearity in PA;

Figure 5 shows a model for envelope frequency dependent non-linearity in PA;

Figure 6 shows an overall transfer function of the PA;

Figure 7 shows a simulation set-up;

Figure 8 shows a block diagram of a predistorter configured for Device A;

Figure 9 shows Error Power improvement for Device A;

Figure 10 shows spectral improvement for Device A;

Figure 11 shows a block diagram of an equaliser configured for Device B;

Figure 12 shows Error Power reduction for Device B;

Figure 13 shows spectral improvements for Device B;

Figure 14 shows an APE RF-ASIC device configured as a 5th order predistorter;

Figure 15 shows an APE RF-ASIC device configured for envelope frequency (3rd order) compensation;

Figure 16 shows an arrangement of APE RF-ASIC devices suitable for performing envelope and carrier frequency equalisation; and

Figure 17 shows a block diagram of an implementation of an APE in a feed forward loop.

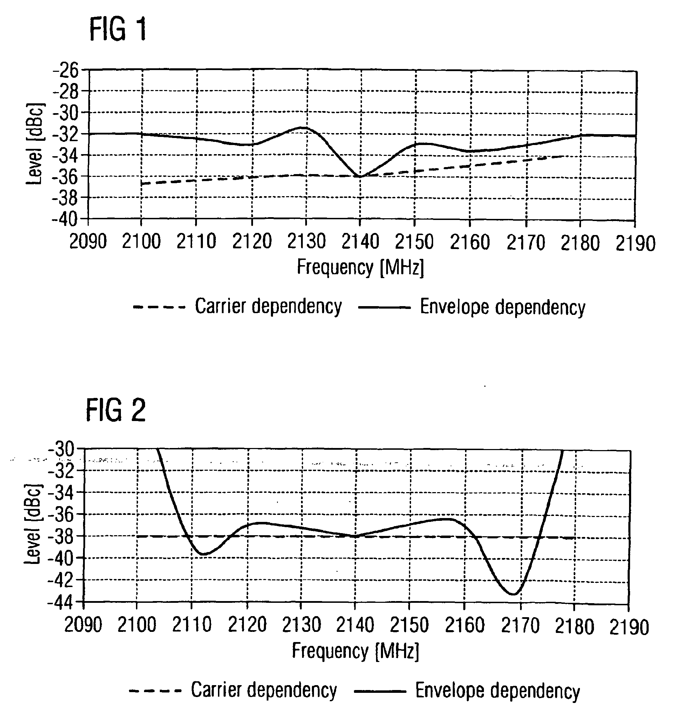

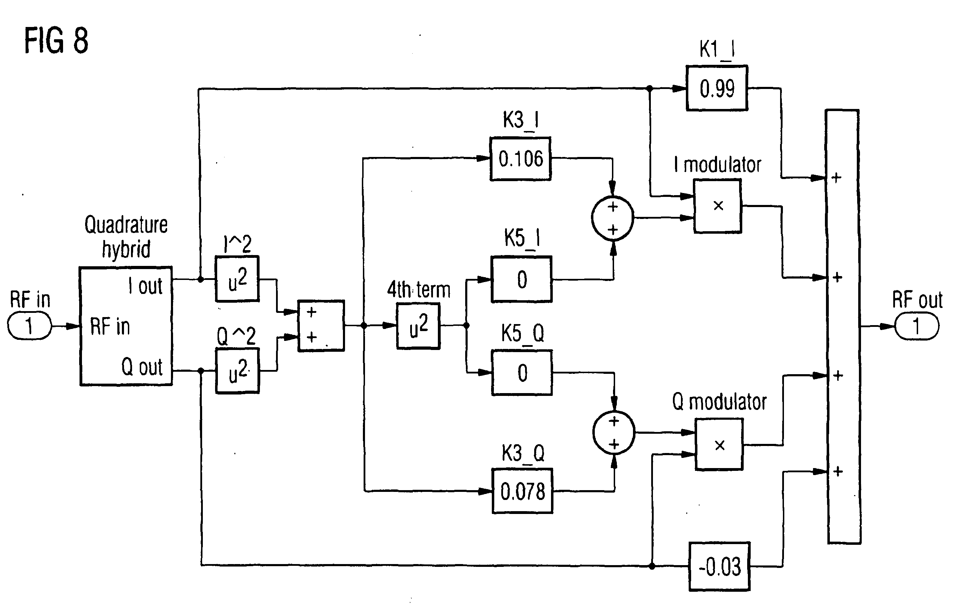

To illustrate the types of memory effects which prior art predistorters find problematic, the results of non-linear memory measurements are disclosed and a simulation model is derived (see Figures 1 to 7). Block diagrams and architectural drawings of configurations and applications of the predistorter of the present invention are shown in Figures 8 to 17.

The non-linear-memory is manifested by variation of IM3 side band levels and side band symmetry over the frequency range. The levels are dependent on the envelope frequency, and the carrier frequency. The significance of memory effects is well known.

There are many examples of linear amplifier devices which may be adopted in base stations. For the purposes of the following discussion two known devices are considered: Device A and Device B. Both devices have been tested for two-tone inter-modulation over carrier and envelope frequency. The test results are shown in Figures 1 (Device A) and 2 (Device B).

In Device A, the IM3 products are shown to have a slight dependence on carrier frequency. The envelope dependency is stronger; there is a resonance at dF=10MHz.

In the case of Device B, the IM3 products are not dependent on carrier frequency. The envelope dependency is very small between 2110MHz to 2160MHz, but there is a strong resonance at the band edge (dF=25-30MHz).

It is important to note that in both devices, the 5th order distortion is 8-10dB below the 3rd order products. This indicates that the higher order terms could be neglected at the drive levels at which the measurements of Figure 1 and Figure 2 were taken.

In the case of practical power amplifiers (PA), the carrier frequency dependent 3rd order non-linearity and the envelope frequency dependent 3rd order non-linearity dominates the transfer function. This is confirmed by measurements such as the studies of Devices A and B described above, which indicate that the 5th and higher order terms are generally 8-10dB below the 3rd order products for a PA that operates at 20-30% efficiency.

In order to understand the behaviour of practical PAs it has been considered useful to develop a general model of these devices. Power amplifiers with memory can be modelled using Volterra series. Volterra series are considered particularly appropriate when non-linear effects are weak but not insignificant.

M. Schetzen describes the Volterra series and its application for non-linear systems in detail in "Volterra and Wiener Theories of Non-linear System", Schetzen, M. (1980) John Wiley & Sons, [ISBN 0-471-04455-5].

The general expression for a 2p-1 order model is given by the equation 1:

$$y_n = \sum_{i_1=0}^{M-1} h_{i_1}^{(1)} x_{n-i_1} + \sum_{i_1=0}^{M-1}\sum_{i_2=0}^{M-1}\sum_{i_3=0}^{M-1} h_{i_1,i_2,i_3}^{(3)} x_{n-i_1} x_{n-i_2} x_{n-i_3}^{*} + \sum_{i_1=0}^{M-1} \cdots \sum_{i_{2p-1}=0}^{M-1} h_{i_1,\dots i_{2p-1}}^{(2p-1)} x_{n-i_1} \cdots x_{n-i_p} x_{n-i_{p+1}}^{*} \cdots x_{n-i_{2p-1}}^{*}$$

To represent the carrier frequency effects, the indices $i_1$, $i_2$ and $i_3$ in equation 1 are set as follows:

| $i_1$ | $i_2$ | $i_3$ |
|---|---|---|
| 0 | 0 | 0 |
| 1 | 0 | 0 |
| . | . | . |
| . | . | . |
| . | . | . |
| $M$-1 | 0 | 0 |

For the envelope frequency dependent term, the indices are set as follows:

| $i_1$ | $i_2$ | $i_3$ |
|---|---|---|
| 0 | 0 | 0 |
| 0 | 1 | 1 |
| . | . | . |
| . | . | . |
| . | . | . |
| 0 | $M$-1 | $M$-1 |

Using the reduced set of indices, equation 1 can be truncated to deal with three dominant effects: 1) Linear transfer function, 2) 3rd order carrier frequency dependent transfer function and 3) 3rd order envelope frequency dependent transfer function. The truncation gives a simplified model as set out in equation 2:

$$y_n = \sum_{i_1=0}^{M-1} h_{i_1}^{(1)} x_{n-i_1} + |x_n|^2 \sum_{i_2=0}^{M-1} h_{i_2}^{(3cw)} x_{n-i_2} + x_n \sum_{i_3=0}^{M-1} h_{i_3}^{(3env)} |x_{n-i_3}|^2$$

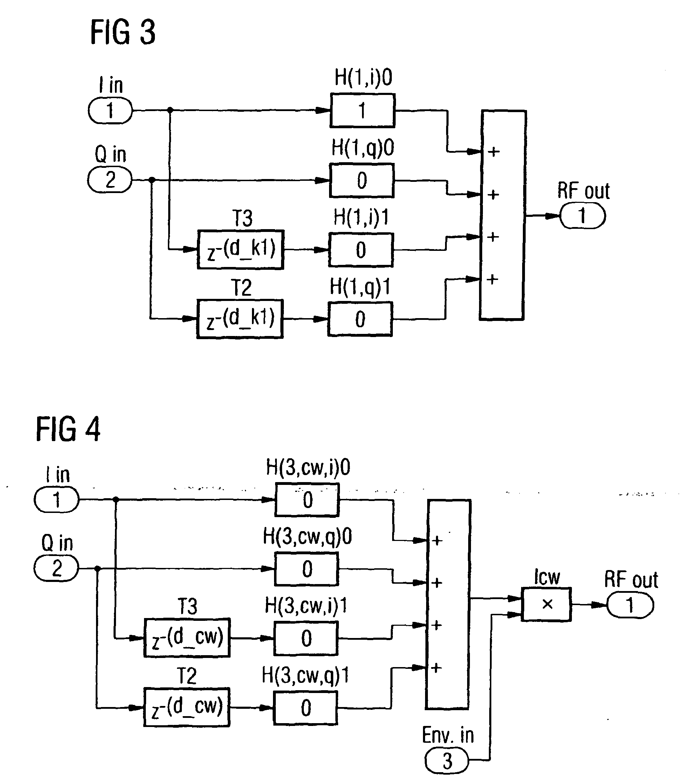

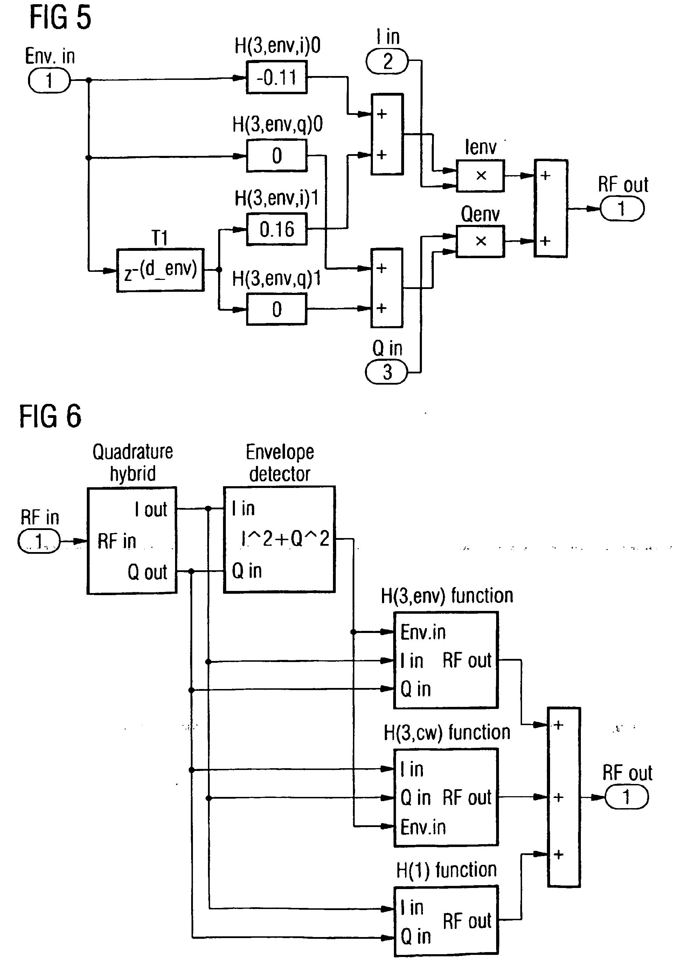

A simplified model of PA behaviour based on equation 2 has been implemented. The block diagrams for each term of the equation are shown in Figures 3, 4 and 5 respectively. Figure 6 shows the block diagram generated to simulate the overall transfer function of the power amplifier.

For simplicity, the impulse response for each term is implemented by single delay element that forms a two-tap FIR (finite impulse response) structure. Such a simple structure can produce a slope or a single curvature in an output signal which is adequate to represent the measured response of devices such as Device A or Device B (Figures 1 and 2).

It should be noted that all coefficients in the above discussion of equations 1 and 2 are complex coefficients. This means that both AM/AM and AM/PM effects can be modelled (AM being, amplitude modulation, PM being phase modulation). However, measurements made on spectral density only (using a spectrum analyser), do not allow the AM and the PM sidebands to be distinguished.

The block diagrams in Figures 3 to 6 seek to model the behaviour of known PA devices. The coefficients in Figures 3, 4 and 5 were set to produce a ripple similar in magnitude to that of measured values the device to be modelled: for Device A and Device B, the ripple produced is similar to that in Figure 1 and Figure 2 respectively.

For example, the model of Device A has a linear ripple of+/-0.25 dB (not shown on Figure 1), the CW (carrier wave) dependent sidebands varied between -34dBc to -36dBc and the envelope dependent sidebands varied between -32dBc to -36dBc. Throughout, the notation dBc denotes the dB measured relative to the carrier signal amplitude.

Where no carrier frequency dependency is evident in a device for modelling, e.g. Device B, the linear ripple and the carrier frequency dependent variation are set to zero. The model of Device B does however allow the envelope dependent IM3 sidebands to vary between -25dBc to-35dBc.

It should further be noted that the high level of -25dBc envelope dependent sidebands only occurs at the band edges. In practice, this resonance can be moved out of band and thereby avoided. However, in order to confirm the feasibility of an adaptive polynomial equaliser, the simulation allowed for variations of the order measured for Device B.

The purpose of the simulation was: firstly, to confirm that the simplified Volterra model, which was derived from the two-tone measurements, is also valid for the general multi-carrier case; but also to estimate the achievable Peak Error power Ratio (PER) for Device A and for Device B respectively. The estimation of achievable PER being made both using a polynomial predistorter, without memory, and using an adaptive polynomial equaliser, which gives predistortion with memory.

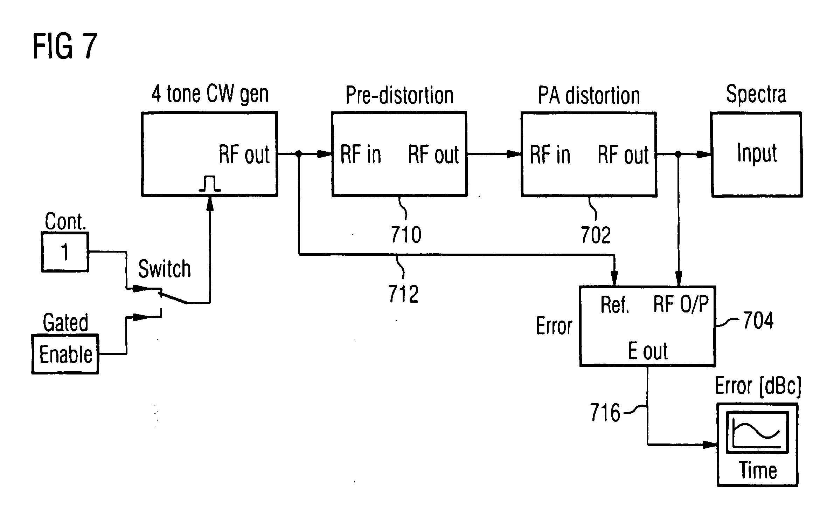

The simulation set-up is shown in Figure 7. The PA distortion block 702 is based on the simplified Volterra model as illustrated in Figures 3 to 6.

Under the simulation, the signal source comprises four equal CW tones; the frequencies are set to excite a variety of IM3 products. The simulated test case represents a typical multi-carrier scenario.

The Error block 704 calculates the difference between the reference 712 and the output signal 714. This calculation bears some similarity to a signal cancellation loop in.a feed forward circuit. The error signal 716 is plotted relative to the Peak Envelope Power of the reference signal.

The model operates in continuous and gated modes for observing the spectra and the time domain waveforms respectively.

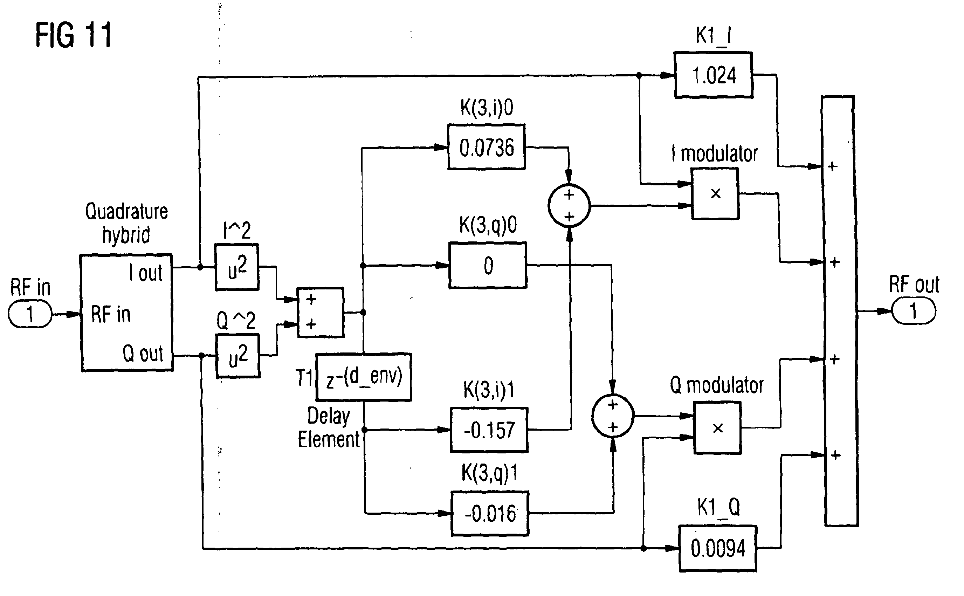

The properties of the PA models are summarised in Table 1 below. The model of Device A (shown in Figure 8) simulates a weak memory case. On the other hand the model of Device B (shown in Figure 11) requires stronger memory simulation:

**Table 1**

| Model Name | Device A | Device B |
| --- | --- | --- |
| Linear response ripple | +/-0.25dB | 0dB |
| Carrier Dependent IM3 levels | Min. -36dBc<br>Max. -34dBc | -35dBc<br>+/-0dB |
| Envelope Dependent IM3 levels | Min -36dBc<br>Max -32dBc | Min -35dBc<br>Max -25dBc |

The predistorter block 710 in Figure 7 is reconfigured to compensate for each respective PA distorter block 702. Thus the predistorter in Figure 8 corresponds to the model of Device A and similarly the predistorter in Figure 11 corresponds to the model of Device B.

It will be noted that the Device A predistorter in Figure 8 does not have any delay elements and cannot, therefore compensate for memory. However, as has been noted earlier, Device A does have a relatively small sideband ripple.

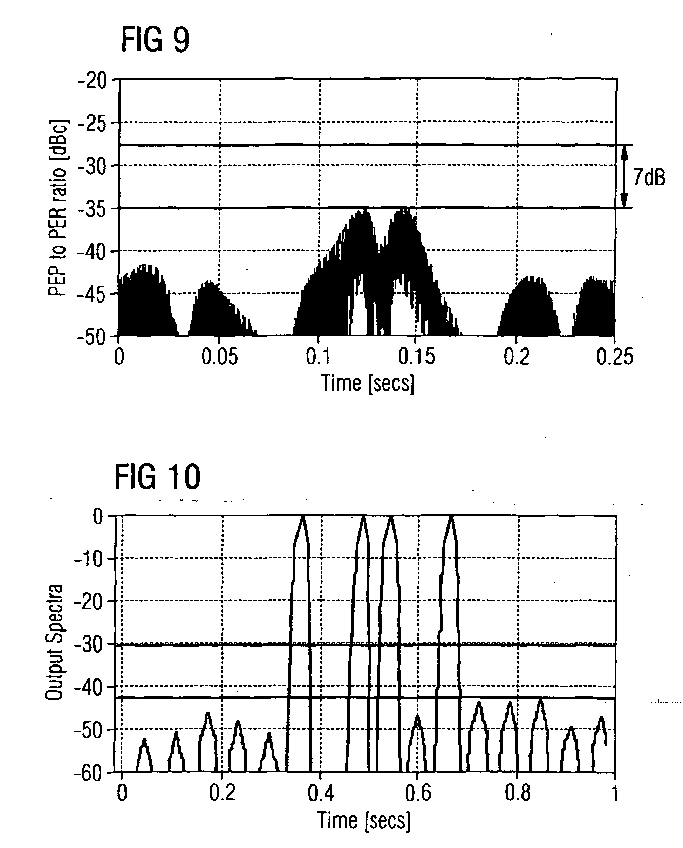

The error signal 716 from the system with Device A is shown in Figure 9. The Peak Error Ratio improves by 7dB (i.e. from -28dBc to -35dBc). The spectrum of the output signal 714 is shown in Figure 10. Here too improvement can be observed.

In terms of the expected performance in a Feed Forward Loop, at 80W PEP, the Peak Error Power is only 25mW. The Error amplifier needs to deliver only 250mW peak when used with a 10dB output coupler.

It is interesting point out that the 5th order coefficients of Figure 8 are set to zero. In further research, it has been found that these terms could not reduce the peak error any further, so these terms are not essential in the RF-ASIC implementation.

The.polynomial predistorter model (Figure 8) performed very poorly when applied to the Device B model. Only 1dB PER improvement was achieved. Given the strong memory component included in the Device B model, this poor performance was expected. In order to achieve better cancellation, an adaptive polynomial equaliser which includes delay (memory) is required.

The required equaliser comprises essentially the same building blocks as the predistorter of Figure 8. However, as may be seen from the block diagram in Figure 11, a delay element (T1) is now added and the multipliers are re-configured to produce two sets of IM3 products (instead of a single 3rd order term and a 5th order term).

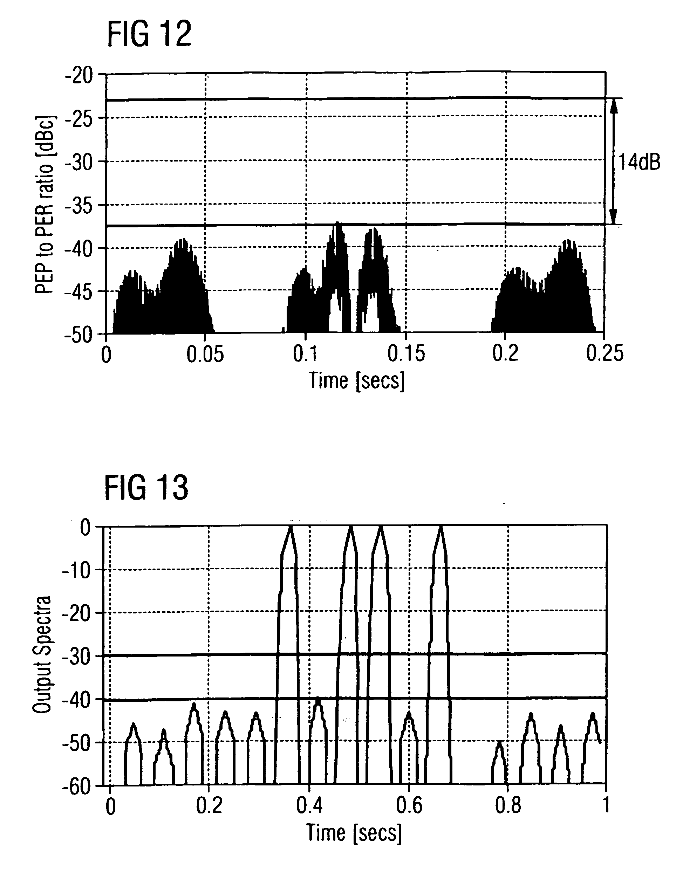

As remarked above a simple arrangement with two taps is able to generate a slope or a curvature. Here the two-tap FIR structure is used to equalise the envelope dependent transfer function of the power amplifier. The achievable improvement using the predistorter of Fig. 11 with the Device B model is shown by Figures 12 and 13.

The equaliser reduced the Peak Error Power to -37dBc. For the purposes of the simulation, this was achieved by manually adjusting the coefficients for minimum Peak Error Power. In the real system, the same task can be performed adaptively using a minimum PEP search algorithm.

In terms of the simulated performance in a Feed Forward Loop, at 86W PEP, the Peak Error Power is now only 20mW. The Error amplifier needs to deliver only 200mW peak when used with a 10dB output coupler.

It should be noted, that the improvement of 14dB illustrated in Figure 12 can not be guaranteed in anything other than special cases: the simple PA model produced a smooth curve instead of the sharp ripple as shown on Figure 2. For accurate realisation of the distortion (and for its inverse) a larger number of taps will be required, corresponding to a longer delay (memory).

Accurate realisation of the distortion may be achieved with digital predistortion. On the other hand, there is no benefit from more than 10dB improvement because the 5th and higher order terms are present at 8-10dB below anyway.

In one embodiment of the present invention, an apparatus for compensating for the IMD products generated in PAs is provided. The compensating apparatus is configurable in accordance with the transfer characteristics of the PA for which it compensates. Thus the compensating apparatus can be configured to emulate the models in both Figures 8 and 11.

As remarked earlier, one preferred embodiment of the compensating apparatus is as an RF-ASIC, also referred to as an APE.

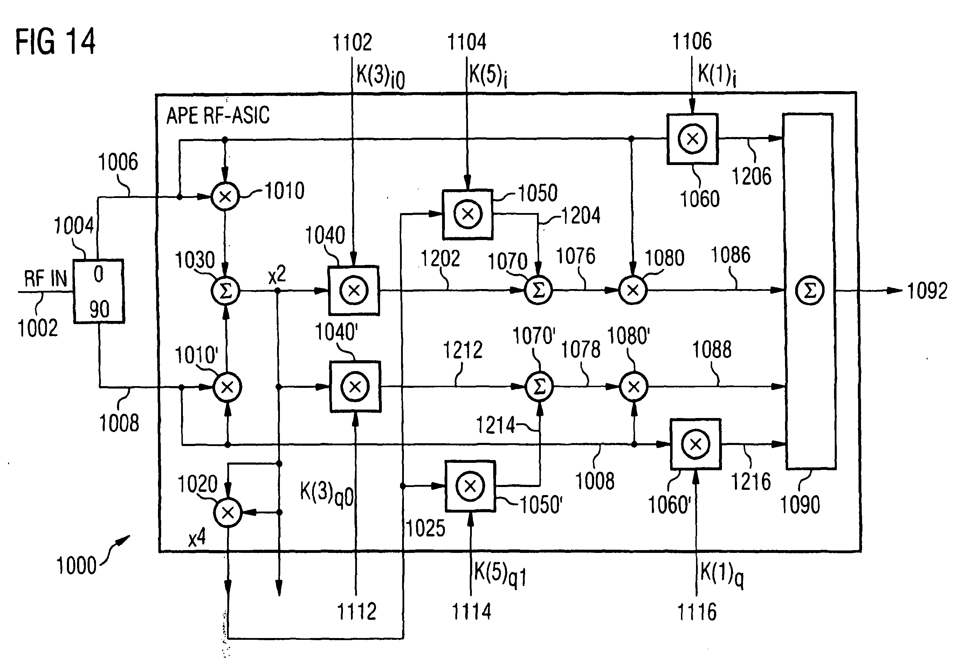

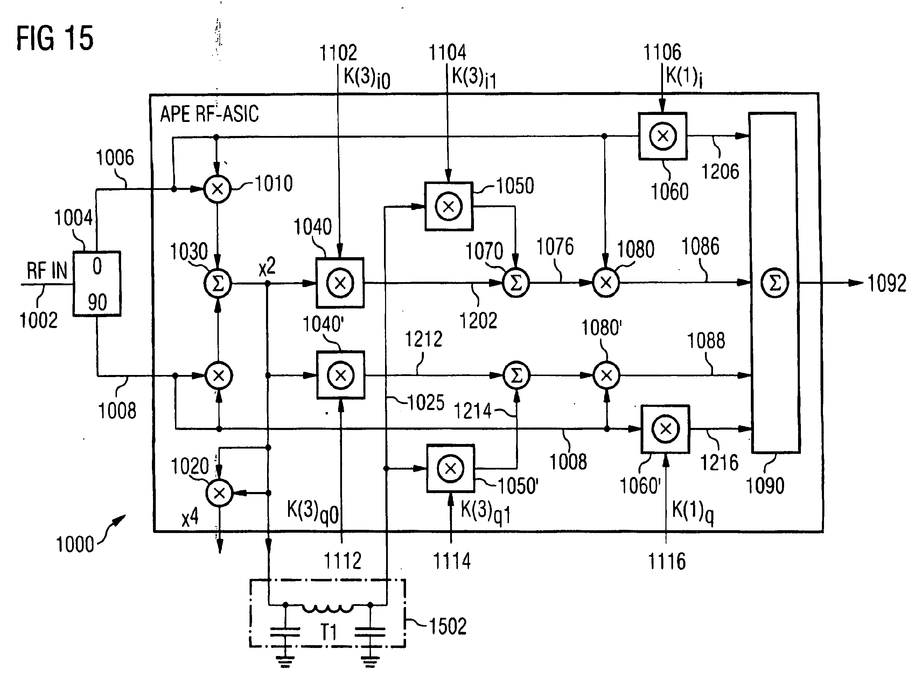

It has been realised that the block diagram in Figure 11 and the block diagram in Figure 8 can be constructed using the same RF-ASIC components. Each block diagram can be emulated as a special case (see Figure 14 and 15 respectively).

The APE provides predistortion and equalisation in Feed Forward loops. The benefits of this solution are summarised as follows:

Firstly the predistortion, improves both the efficiency and the spectral purity of the main amplifier.

Secondly, the non-linear equalisation can adapt to the frequency-variant compression characteristics of the main amplifier.

Thirdly, the error power is reduced; smaller error amplifier is required which has larger bandwidth and smaller electrical delay and delay ripple.

Finally, very short output matching delay is needed, hence the output loss is lower, and the cancellation is better. The filter delay line may be replaced with low cost coax or a printed track.

A further advantage of the present invention is that the same RF-ASIC can be configured either as a 5$^{th}$ order predistorter or as a 3$^{rd}$ order non-linear equaliser.

The structure of one implementation of the APE RF-ASIC can be described with reference to either of Figures 14 or 15, the same reference numerals are used in both Figures for like components. An RF signal 1002 is phase-split into an in-phase 1006 and a quadrature component 1008 (I and Q) by a phase-splitter 1004. The two components 1006,1008 are input into respective multipliers 1010,1010'. Each multiplier squares the amplitude value for the corresponding component and the squared amplitudes are summed at an adder 1030 to give an $X^2$ signal. The $X^2$ signal itself is fed to a further multiplier 1020 where the $X^2$ value is squared again to give a $X^4$ signal.

Consider now the treatment of the in-phase component 1006 only. A symmetrical treatment is given to the quadrature phase component 1008. Three combiners 1040,1050,1060 are provided each suitable for combining an RF signal with a corresponding coefficient provided by a controller device (not shown). The first of these combiners 1040 takes a first coefficient 1102 and the $X^2$ signal as input and generates a first combined signal 1202. The second combiner 1050 takes a second coefficient 1104 and an external signal 1025 as input and generates a second combined signal 1204. The first and second combined signals 1202,1204 are added by an adder 1070 to give a sum 1076. The sum 1076 and the in-phase component 1006 are input into a multiplier 1080: the result being a first summand 1086.

The in-phase component 1006 is also input into the third combiner 1060 where it is combined with a third coefficient 1106. The output of the third combiner 1060 is a second summand 1206. The symmetrical quadrature path results in two further summands 1088, 1216. All four summands are summed in an adder 1090. The output of the adder 1090 is a predistorted signal 1092. Provided the input coefficients are appropriate to a given PA, the predistorted signal 1092 should be compensated for at least some of the dominant mixing products in the PA transfer characteristics.

For completeness the quadrature path is also described. There are three more combiners 1040', 1050', 1060', each suitable for combining an RF signal with a corresponding coefficient provided by a controller device (not shown). The fourth combiner 1040' takes a first coefficient 1112 and the $X^2$ signal as input and generates a fourth combined signal 1212. The fifth combiner 1050' takes a second coefficient 1114 and the external signal 1025 as input and generates a fifth combined signal 1214. The fourth and fifth combined signals 1212,1214 are added by an adder 1070' to give a sum 1078. The sum 1078 and the quadrature component 1008 are input into a multiplier 1080: the result being the third summand 1088.

The quadrature component 1008 is also input into the sixth combiner 1060' where it is combined with a sixth coefficient 1116. The output of the sixth combiner 1060' is the fourth summand 1216.

In the examples of configurations of the RF-ASIC, the first and fourth coefficients 1102,1112 are 3$^{rd}$ order coefficients $K^{(3)}_{x1}$. Likewise the third and sixth coefficients 1106,1116 are 1$^{st}$ order coefficients $K^{(1)}_{x}$.

The RF-ASIC is thus, with little rearrangement, configurable as either a 5th order polynomial predistorter, in which case the external signal 1025 is the $X^4$ signal generated at the multiplier 1020, or a 3rd order equaliser, in which case the external signal 1025 is the $X^2$ signal delayed by an external circuit 1502. The second and fifth coefficients 1104,1114 supplied to the second and fifth combiners 1050,1050' are 5$^{th}$ order $K^{(5)}_{x}$ or 3$^{rd}$ order $K^{(3)}_{x1}$ respectively.

Note that the $X^2$ and $X^4$ signals are taken off-chip and the $X^4$ signal is routed back in the Figure 14 arrangement.

For narrowband applications (BW 5MHz to 20MHz), the dispersion of the non-linearity in the PA over frequency may be negligible. In this case, it is advantageous to configure the RF-ASIC as a 5th order polynomial predistorter. This configuration is shown in Figure 14.

For wider bandwidth applications (BW= 30MHz-100MHz), the compression characteristics of the main amplifier may vary over frequency. In these cases, better cancellation is achieved by configuring the RF-ASIC for 3rd order equalisation of the transfer function. This arrangement is shown in Figure 15.

This arrangement implements the envelope-dependent term in equation 2 described above and is equivalent to the model in Figure 11. T1 delay is realised by an external LC circuit 1502 in this example.

It should be noted, that two or more APE RF-ASIC circuits can be cascaded to realise more complicated impulse responses. It is also possible to include carrier frequency dependent terms in the RF-ASIC.

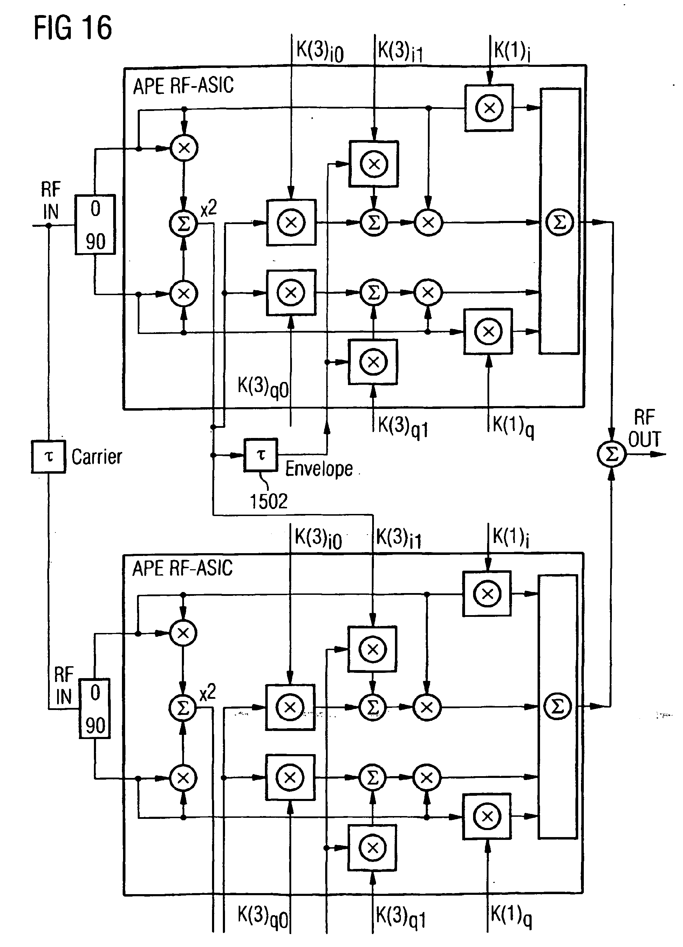

In a further embodiment of the present invention, two RF-ASIC blocks are arranged to compensate for both envelope and carrier frequency effects. An illustration of such a configuration is shown in Figure 16.

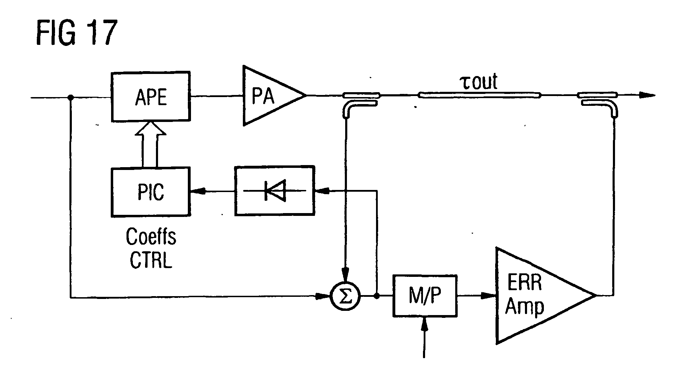

In yet another embodiment of the present invention, an APE is incorporated in a feed forward loop. This embodiment is illustrated is shown in Figure 17.

The error signal is detected and applied to a microcontroller (PIC). The search algorithm (e.g. perturbation loop) may be coded into the PIC, which also includes all the necessary ADC/DAC converters.

The APE also fulfils the functionality of the vector modulator in the cancellation loop. This is accomplished by the complex K1 coefficient.

It has been shown that memory effects are generally weak in well-designed power amplifiers. The carrier frequency dependent terms can usually be neglected. The APE predistorter can compensate for the envelope frequency dependent terms, if necessary.

The APE technique improves both the bandwidth and the efficiency of feed forward amplifiers whilst also reducing the costs of hardware. The APE is a key technique for the implementing multi-carrier power amplifier that simultaneously covers the full RF DCS/PCS/FDD bandwidths.

## Claims

1. A compensating apparatus for compensating for intermodulation products, the apparatus comprising:

   a phase splitting unit (1004), which splits an input RF signal (1002) into an in-phase component (1006) and a quadrature component (1008);
   first multiplying units (1010, 1010'), which square the value of the in-phase component and the quadrature component respectively;
   a first summer (1030) which sums the squared values to generate an $X^2$ signal;
   combining units (1040, 1050, 1060, 1040', 1050', 1060'), which respectively combine the $X^2$ signal, the in-phase component, the quadrature component, and an external signal (1025) with respective predistorting coefficients (1102, 1112; 1106; 1116; 1104, 1114); and an adder (1090), which generates a predistorted RF signal (1092) from the output of the combining units.

2. A compensating apparatus according to claim 1 wherein the combining units comprise fist to sixth combining units, the first combining unit (1040) combining the $X^2$ signal with a first predistorting coefficient (1102); the second combining unit (1040') combining the $X^2$ signal with a second predistorting coefficient (1112); the third combining unit (1050) combining the external signal with a third predistorting coefficient (1104); the fourth combining unit (1050') combining the external signal with a fourth predistorting coefficient (1114); the fifth combining unit (1060) combining the in-phase component with a fifth predistorting coefficient (1106); the sixth combining unit (1060') combining the in-phase component with a sixth predistorting coefficient (1116).

3. A compensating apparatus according to claim 2, further comprising a second summer (1070) summing the outputs of first and third combining units; and a third summer (1070') summing the outputs of second and fourth combining units.

4. A compensating apparatus according to claim 3 further comprising a second multiplying unit (1080) which multiplies the output of the second summer with the in-phase component; and a third multiplying unit (1080') which multiplies the output of the third summer with the quadrature component, and wherein the adder sums the outputs of the firth combining unit, the sixth combining unit, the second multiplying unit and the third multiplying unit to produce a predistorted RF signal.

5. A compensating apparatus as claimed in any preceding Claim, wherein the apparatus is an application specific integrated circuit.

6. A compensating apparatus as claimed in any preceding Claim, wherein an output carrying the $X^2$ signal is coupled

to a delay unit (1502, T1) and the output of the delay unit is fed back into the apparatus as the external signal (1025), whereby the external signal is a delayed signal derived from the $X^2$ signal.

7. A compensating apparatus as claimed in any of Claims 1-5, the apparatus comprising a further multiplier (1020), which squares the $X^2$ signal again to give a $X^4$ signal, wherein the external signal (1025) is the $X^4$ signal.

8. A hybrid compensating apparatus for substantially simultaneously compensating for both carrier frequency and envelope frequency dependent effects due to IM3 products, the hybrid apparatus comprising:

- a first compensating apparatus as claimed in Claim 6, arranged to compensate for envelope frequency effects;
- a second compensating apparatus as claimed in any of claims 1-5, arranged to compensate for carrier frequency effects;
- a carrier delay unit, which imposes a predetermined delay upon the RF input signal supplied to the second compensating apparatus; and
- a further adder which sums the outputs of the first and second compensating apparatuses.

9. A feed forward amplifier arrangement comprising:

- a compensating apparatus (APE) as claimed in any of the preceding claims;
- an amplifier (PA) having non-linear transfer characteristics that distort signals amplified thereby, the amplifier being coupled to the output of the compensating apparatus;
- a controller (PIC) which generates coefficients for feeding into the compensating apparatus; and
- a sampling means which samples an output signal from the amplifier and which feeds the sample back to the controller.

10. A method of compensating for intermodulation products, the method comprising:

splitting (1004) an input RF signal (1002) into an in-phase component (1006) and a quadrature component (1008);
squaring (1010, 1010') the in-phase component and the quadrature component respectively and summing (1030) their squares to generate an $X^2$ signal;
combining (1040, 1050, 1070, 1080, 1040', 1050', 1070', 1080') the $X^2$ signal, the in-phase and quadrature components, and an external signal (1025) with respective predistorting coefficients (1102, 1104, 1112, 1114); and
generating (1090) a predistorted RF signal (1092).

11. A method according to claim 10 wherein the combining step comprises fist to sixth combining operations,
the first combining operation (1040) combining the $X^2$ signal with a first predistorting coefficient (1102);
the second combining operation (1040') combining the $X^2$ signal with a second predistorting coefficient (1112);
the third combining operation (1050) combining the external signal with a third predistorting coefficient (1104);
the fourth combining operation (1050') combining the external signal with a fourth predistorting coefficient (1114);
the fifth combining operation (1060) combining the in-phase component with a fifth predistorting coefficient (1106);
the sixth combining operation (1060') combining the in-phase component with a sixth predistorting coefficient (1116).

12. A method according to claim 11, further comprising a second summing operation (1070) of summing the results of first and third combining operations; and a third summing operation (1070') of summing the results of second and fourth combining operations.

13. A compensating apparatus according to claim 12 further comprising a second multiplying operation (1080) which multiplies the output of the second summing operation with the in-phase component; and a third multiplying operation (1080') which multiplies the output of the third summing operation with the quadrature component, and wherein the step of generating a predistorted RF signal comprises summing the results of the firth combining operation, the sixth combining operation, the second multiplying operation and the third multiplying operation.

14. A method as claimed in any of claims 10-13, wherein the external signal is a delayed (1502) signal derived from the $X^2$ signal.

15. A method as claimed in any of claims 10-13, wherein the method further comprises squaring (1020) the $X^2$ signal

to generate a $X^4$ signal and wherein the external signal (1025) is the $X^4$ signal.

**Patentansprüche**

1. Kompensationsvorrichtung zum Kompensieren von Intermodulationsprodukten, wobei die Vorrichtung umfasst:

   einen Phasenteilerblock (1004), welcher ein Eingangs-Hochfrequenzsignal (1002) in eine gleichphasige Komponente (1006) und eine Quadraturkomponente (1008) aufspaltet;
   erste Multiplizierglieder (1010, 1010'), welche den Wert der gleichphasigen Komponente bzw. der Quadraturkomponente quadrieren;
   einen ersten Addierer (1030), welcher die quadrierten Werte addiert, um ein $X^2$-Signal zu erzeugen; Kombinationsglieder (1040, 1050, 1060, 1040', 1050', 1060'), welche das $X^2$-Signal, die gleichphasige Komponente, die Quadraturkomponente und ein externes Signal (1025) mit jeweiligen Vorverzerrungskoeffizienten (1102, 1112; 1106; 1116; 1104, 1114) kombinieren; und
   einen Addierer (1090), welcher aus dem Ausgang der Kombinationsglieder ein vorverzerrtes Hochfrequenzsignal (1092) erzeugt.

2. Kompensationsvorrichtung nach Anspruch 1, wobei die Kombinationsglieder ein erstes bis sechstes Kombinationsglied umfassen,
   wobei das erste Kombinationsglied (1040) das $X^2$-Signal mit einem ersten Vorverzerrungskoeffizienten (1102) kombiniert;
   wobei das zweite Kombinationsglied (1040') das $X^2$-Signal mit einem zweiten Vorverzerrungskoeffizienten (1112) kombiniert;
   wobei das dritte Kombinationsglied (1050) das externe Signal mit einem dritten Vorverzerrungskoeffizienten (1104) kombiniert;
   wobei das vierte Kombinationsglied (1050') das externe Signal mit einem vierten Vorverzerrungskoeffizienten (1114) kombiniert;
   wobei das fünfte Kombinationsglied (1060) die gleichphasige Komponente mit einem fünften Vorverzerrungskoeffizienten (1106) kombiniert;
   wobei das sechste Kombinationsglied (1060') die gleichphasige Komponente mit einem sechsten Vorverzerrungskoeffizienten (1116) kombiniert.

3. Kompensationsvorrichtung nach Anspruch 2, welche ferner umfasst: einen zweiten Addierer (1070), welcher die Ausgänge des ersten und dritten Kombinationsgliedes addiert; und einen dritten Addierer (1070'), welcher die Ausgänge des zweiten und vierten Kombinationsgliedes addiert.

4. Kompensationsvorrichtung nach Anspruch 3, welche ferner umfasst: ein zweites Multiplizierglied (1080), welches den Ausgang des zweiten Addierers mit der gleichphasigen Komponente multipliziert; und ein drittes Multiplizierglied (1080'), welches den Ausgang des dritten Addierers mit der Quadraturkomponente multipliziert, und wobei der Addierer die Ausgänge des fünften Kombinationsgliedes, des sechsten Kombinationsgliedes, des zweiten Multipliziergliedes und des dritten Multipliziergliedes addiert, um ein vorverzerrtes Hochfrequenzsignal zu erzeugen.

5. Kompensationsvorrichtung nach einem der vorhergehenden Ansprüche, wobei die Vorrichtung eine anwendungsspezifische integrierte Schaltung ist.

6. Kompensationsvorrichtung nach einem der vorhergehenden Ansprüche, wobei ein Ausgang, der das $X^2$-Signal transportiert, mit einem Verzögerungsglied (1502, T1) gekoppelt ist und der Ausgang des Verzögerungsgliedes als das externe Signal (1025) zu der Vorrichtung zurückgeführt wird, wodurch das externe Signal ein verzögertes Signal ist, das von dem $X^2$-Signal abgeleitet ist.

7. Kompensationsvorrichtung nach einem der Ansprüche 1-5,
   wobei die Vorrichtung einen weiteren Multiplizierer (1020) umfasst, welcher das $X^2$-Signal nochmals quadriert, um ein $X^4$-Signal zu erzeugen, wobei das externe Signal (1025) das $X^4$-Signal ist.

8. Hybride Kompensationsvorrichtung zum im Wesentlichen gleichzeitigen Kompensieren sowohl der von der Trägerfrequenz als auch der von der Hüllkurvenfrequenz abhängigen Effekte, die auf IM3-Produkte zurückzuführen sind, wobei die hybride Vorrichtung umfasst:

- eine erste Kompensationsvorrichtung nach Anspruch 6, die so beschaffen ist, dass sie Effekte der Hüllkurvenfrequenz kompensiert;
- eine zweite Kompensationsvorrichtung nach einem der Ansprüche 1-5, die so beschaffen ist, dass sie Effekte der Trägerfrequenz kompensiert;
- ein Träger-Verzögerungsglied, welches das Hochfrequenz-Eingangssignal, das der zweiten Kompensationsvorrichtung zugeführt wird, einer vorgegeben Verzögerung unterwirft; und
- einen weiteren Addierer, welcher die Ausgänge der ersten und der zweiten Kompensationsvorrichtung addiert.

9. Feed-Forward-Verstärkeranordnung, welche umfasst:

- eine Kompensationsvorrichtung (APE) nach einem der vorhergehenden Ansprüche;
- einen Verstärker (LV), der nichtlineare Übertragungscharakteristiken aufweist, welche durch ihn verstärkte Signale verzerren, wobei der Verstärker mit dem Ausgang der Kompensationsvorrichtung gekoppelt ist;
- ein Steuergerät (PIC), welches Koeffizienten zum Einspeisen in die Kompensationsvorrichtung erzeugt; und
- ein Abtastmittel, welches ein Ausgangssignal des Verstärkers abtastet und welches den Abtastwert zum Steuergerät zurückführt.

10. Verfahren zum Kompensieren von Intermodulationsprodukten, wobei das Verfahren umfasst:

Aufspalten (1004) eines Eingangs-Hochfrequenzsignals (1002) in eine gleichphasige Komponente (1006) und eine Quadraturkomponente (1008);
Quadrieren (1010, 1010') der gleichphasigen Komponente bzw. der Quadraturkomponente und Addieren (1030) ihrer Quadrate, um ein $X^2$-Signal zu erzeugen;
Kombinieren (1040, 1050, 1070, 1080, 1040', 1050', 1070', 1080') des $X^2$-Signals, der gleichphasigen und der Quadraturkomponente und eines externen Signals (1025) mit jeweiligen Vorverzerrungskoeffizienten (1102, 1104, 1112, 1114); und
Erzeugen (1090) eines vorverzerrten Hochfrequenzsignals (1092).

11. Verfahren nach Anspruch 10, wobei der Schritt des Kombinierens einen ersten bis sechsten Kombiniervorgang umfasst,
wobei der erste Kombiniervorgang (1040) das $X^2$-Signal mit einem ersten Vorverzerrungskoeffizienten (1102) kombiniert;
wobei der zweite Kombiniervorgang (1040') das $X^2$-Signal mit einem zweiten Vorverzerrungskoeffizienten (1112) kombiniert;
wobei der dritte Kombiniervorgang (1050) das externe Signal mit einem dritten Vorverzerrungskoeffizienten (1104) kombiniert;
wobei der vierte Kombiniervorgang (1050') das externe Signal mit einem vierten Vorverzerrungskoeffizienten (1114) kombiniert;
wobei der fünfte Kombiniervorgang (1060) die gleichphasige Komponente mit einem fünften Vorverzerrungskoeffizienten (1106) kombiniert;
wobei der sechste Kombiniervorgang (1060') die gleichphasige Komponente mit einem sechsten Vorverzerrungskoeffizienten (1116) kombiniert.

12. Verfahren nach Anspruch 11, welches ferner umfasst: einen zweiten Additionsvorgang (1070) des Addierens der Ergebnisse des ersten und dritten Kombinationsvorganges; und einen dritten Additionsvorgang (1070') des Addierens der Ergebnisse des zweiten und vierten Kombinationsvorganges.

13. Verfahren nach Anspruch 12, welches ferner umfasst: einen zweiten Multiplikationsvorgang (1080), bei welchem der Ausgang des zweiten Additionsvorganges mit der gleichphasigen Komponente multipliziert wird; und einen dritten Multiplikationsvorgang (1080'), bei welchem der Ausgang des dritten Additionsvorganges mit der Quadraturkomponente multipliziert wird, und wobei der Schritt des Erzeugens eines vorverzerrten Hochfrequenzsignals das Addieren der Ergebnisse des fünften Kombinationsvorganges, des sechsten Kombinationsvorganges, des zweiten Multiplikationsvorganges und des dritten Multiplikationsvorganges umfasst.

14. Verfahren nach einem der Ansprüche 10-13, wobei das externe Signal eine verzögertes (1502) Signal ist, das von dem $X^2$-Signal abgeleitet ist.

15. Verfahren nach einem der Ansprüche 10-13, wobei das Verfahren ferner des Quadrieren (1020) des $X^2$-Signals

umfasst, um ein $X^4$-Signal zu erzeugen, und wobei das externe Signal (1025) das $X^4$-Signal ist.

**Revendications**

1. Appareil de compensation pour compenser des produits d'intermodulation, l'appareil comprenant :

    une unité de déphasage (1004), qui divise un signal RF d'entrée (1002) en une composante en phase (1006) et en une composante en quadrature (1008) ;
    des premières unités de multiplication (1010, 1010'), qui élèvent au carré la valeur, respectivement, de la composante en phase et de la composante en quadrature ;
    un premier sommateur (1030) qui somme les valeurs élevées au carré pour produire un signal $X^2$;
    des unités de combinaison (1040, 1050, 1060, 1040', 1050', 1060'), qui combinent, respectivement, le signal $X^2$, la composante en phase, la composante en quadrature et un signal externe (1025) avec des coefficients de prédistorsion (1102, 1112 ; 1106, 1116 ; 1104, 1114) respectifs, et
    un additionneur (1090), qui produit un signal RF prédistordu (1092) à partir de la sortie des unités de combinaison.

2. Appareil de compensation selon la revendication 1 dans lequel les unités de combinaison comprennent une première à une sixième unités de combinaison,
    la première unité de combinaison (1040) combinant le signal $X^2$ avec un premier coefficient de prédistorsion (1102);
    la deuxième unité de combinaison (1040') combinant le signal $X^2$ avec un deuxième coefficient de prédistorsion (1112) ;
    la troisième unité de combinaison (1050) combinant le signal externe avec un troisième coefficient de prédistorsion (1104) ;
    la quatrième unité de combinaison (1050') combinant le signal externe avec un quatrième coefficient de prédistorsion (1114) ;
    la cinquième unité de combinaison (1060) combinant la composante en phase avec un cinquième coefficient de prédistorsion (1106) ;
    la sixième unité de combinaison (1060') combinant la composante en phase avec un sixième coefficient de prédistorsion (1116).

3. Appareil de compensation selon la revendication 2, comprenant par ailleurs un deuxième sommateur (1070) sommant les sorties de la première et de la troisième unités de combinaison, et un troisième sommateur (1070') sommant les sorties de la deuxième et de la quatrième unités de combinaison.

4. Appareil de compensation selon la revendication 3 comprenant par ailleurs une deuxième unité de multiplication (1080) qui multiplie la sortie du deuxième sommateur par la composante en phase, et une troisième unité de multiplication (1080') qui multiplie la sortie du troisième sommateur par la composante en quadrature, et dans lequel l'additionneur somme les sorties de la cinquième unité de combinaison, de la sixième unité de combinaison, de la deuxième unité de multiplication et de la troisième unité de multiplication pour produire un signal RF prédistordu.

5. Appareil de compensation selon l'une quelconque des revendications précédentes, l'appareil étant un circuit intégré applicatif spécifique.

6. Appareil de compensation selon l'une quelconque des revendications précédentes, dans lequel une sortie transportant le signal $X^2$ est couplée à une unité à retard (1502, T1) et la sortie de l'unité à retard est réinjectée dans l'appareil comme signal externe (1025), ce par quoi le signal externe est un signal retardé dérivé du signal $X^2$.

7. Appareil de compensation selon l'une quelconque des revendications 1-5, l'appareil comprenant un multiplicateur supplémentaire (1020), qui élève à nouveau au carré le signal $X^2$ pour donner un signal $X^4$, le signal externe (1025) étant le signal $X^4$.

8. Appareil de compensation hybride pour compenser de façon sensiblement simultanée à la fois des effets dépendants de la fréquence de la porte et des effets dépendants de la fréquence de l'enveloppe dus à des produits d'IM3, l'appareil hybride comprenant :

    - un premier appareil de compensation selon la revendication 6, agencé pour compenser les effets dus à la fréquence de l'enveloppe ;

- un second appareil de compensation selon l'une quelconque des revendications 1-5, agencé pour compenser les effets dus à la fréquence de la porteuse ;
- une unité à retard de porteuse, qui impose un retard prédéterminé au signal d'entrée RF fourni au second appareil de compensation, et
- un additionneur supplémentaire qui somme les sorties du premier et du second appareils de compensation.

9. Montage formant amplificateur à réaction anticipative comprenant :

- un appareil de compensation (EPA) selon l'une quelconque des revendications précédentes ;
- un amplificateur (AP) ayant des caractéristiques de transfert non linéaires qui distordent les signaux amplifiés par celui-ci, l'amplificateur étant couplé à la sortie de l'appareil de compensation ;
- un contrôleur (PIC) qui produit des coefficients à injecter dans l'appareil de compensation, et
- un moyen d'échantillonnage qui échantillonne un signal de sortie de l'amplificateur et qui réinjecte l'échantillon dans le contrôleur.

10. Procédé de compensation de produits d'intermodulation, le procédé consistant à :

diviser (1104) un signal RF d'entrée (1002) en une composante en phase (1006) et une composante en quadrature (1008) ;

élever au carré (1010, 1010'), respectivement, la composante en phase et la composante en quadrature et sommer (1030) leurs carrés pour produire un signal $X^2$; combiner (1040, 1050, 1070, 1080, 1040', 1050', 1070', 1080') le signal $X^2$, les composantes en phase et en quadrature, et un signal externe (1025) avec des coefficients de prédistorsion (1102, 1104, 1112, 1114) respectifs, et

produire (1090) un signal RF prédistordu (1092).

11. Procédé selon la revendication 10 dans lequel l'étape de combinaison comprend une première à une sixième opérations de combinaison,

la première opération de combinaison (1040) combinant le signal $X^2$ avec un premier coefficient de prédistorsion (1102) ;

la deuxième opération de combinaison (1040') combinant le signal $X^2$ avec un deuxième coefficient de prédistorsion (1112) ;

la troisième opération de combinaison (1050) combinant le signal externe avec un troisième coefficient de prédistorsion (1104) ;

la quatrième opération de combinaison (1050') combinant le signal externe avec un quatrième coefficient de prédistorsion (1114) ;

la cinquième opération de combinaison (1060) combinant la composante en phase avec un cinquième coefficient de prédistorsion (1106) ;

la sixième opération de combinaison (1060') combinant la composante en phase avec un sixième coefficient de prédistorsion (1116).

12. Procédé selon la revendication 11, comprenant par ailleurs une deuxième opération de sommation (1070) consistant à sommer les résultats de la première et de la troisième opérations de combinaison, et une troisième opération de sommation (1070') consistant à sommer les résultats de la deuxième et de la quatrième opérations de combinaison.

13. Appareil de compensation selon la revendication 12 comprenant par ailleurs une deuxième opération de multiplication (1080) qui multiplie la sortie de la deuxième opération de sommation par la composante en phase, et une troisième opération de multiplication (1080') qui multiplie la sortie de la troisième opération de sommation par la composante en quadrature, et dans lequel l'étape de production d'un signal RF prédistordu consiste à sommer les résultats de la première opération de combinaison, de la sixième opération de combinaison, de la deuxième opération de multiplication et de la troisième opération de multiplication.

14. Procédé selon l'une quelconque des revendications 10-13, dans lequel le signal externe est un signal retardé (1502) dérivé du signal $X^2$.

15. Procédé selon l'une quelconque des revendications 10-13, le procédé comprenant par ailleurs l'élévation au carré (1020) du signal $X^2$ pour produire un signal $X^4$ et le signal externe (1025) étant le signal $X^4$.

## FIG 1

Level [dBc] vs Frequency [MHz]

- - - - Carrier dependency ———— Envelope dependency

## FIG 2

Level [dBc] vs Frequency [MHz]

- - - - Carrier dependency ———— Envelope dependency

## FIG 3

## FIG 4

## FIG 5

## FIG 6

**FIG 7**

EP 1 466 408 B1

FIG 8

## FIG 9

## FIG 10

# FIG 11

## FIG 12

## FIG 13

FIG 14

FIG 15

EP 1 466 408 B1

## FIG 16

## FIG 17